(19) Europäisches Patentamt
European Patent Office
Office européen des brevets

(11) **EP 1 424 565 A1**

## (12) EUROPEAN PATENT APPLICATION

(43) Date of publication:
**02.06.2004 Bulletin 2004/23**

(51) Int Cl.$^7$: **G01R 31/28**, G01R 27/28

(21) Application number: **02425736.2**

(22) Date of filing: **29.11.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(71) Applicant: **CNX S.p.A.**
**20126 Milano (IT)**

(72) Inventor: **Ricchiuti, Vittorio**
**67100 L'Aquila (IT)**

(74) Representative: **Giustini, Delio**
**Siemens Mobile Communications S.p.A,**
**Palazzo Gorky**
**Via Monfalcone, 1**
**20092 Cinisello Balsamo (IT)**

(54) **Method of and device for determining the transfer function of a connection on a printed circuit board**

(57) The method enables determining the transfer function of an interconnection made through conductive material tracks traced in printed circuit boards and to evaluate the quality of the signal transmitted on it, eliminating the effects of adapters (SMA) used for the connection to the measuring instrument (VNA).

The method requires the use of two tracks only, having different length laid out the board under test and the availability of a processor and of a Vector Network Analyzer equipped with an option for data transformation from the frequency domain to the time domain.

FIG 1

EP 1 424 565 A1

## Description

## Field of the invention

The invention relates to the domain of electronics dealing with the design and implementation of connections between electronic components, such as microprocessors or integrated circuits, exchanging signals at high frequencies using a conductive material as physical carrier.

Among physical carriers those of major interest, commonly used in the implementation of electronic equipment, are the connections called also simply tracks, obtained employing the construction technologies proper of the implementation of printed circuit boards.

High frequency applications have recourse to particular methods for the realization of the above mentioned connections identified by the sector technicians, based on their geometric characteristics, as: Strip-line, micro-strip, embedded-micro-strip.

One of the fundamental aspects for the design and implementation of said connections is that the transmitted signal maintains the essential characteristics that allow the receiver to understand the transmitted information: the sector technicians refer to these problems as signal integrity problems.

Among the factors that are making the study of signal integrity increasingly important, the most notable one is the increase of transmission frequencies of the signals themselves through electronic components that exceeds even 1 GHz on modern equipment.

As the employed bandwidth increases, the electrical properties of interconnections affect and alter the integrity of the transmitted signals.

An additional critical element is of ever smaller cross-section tracks, but long enough to connect points distant even some tenths of centimetres. This is the case of point-to point connections in integrated circuits, which are assembled on different printed circuit boards interconnected by means of backplanes.

For the implementation of printed circuit boards specific dielectric materials shall be used, having low dielectric loss in order to assure the quality of the signals running on the tracks connecting the different integrated circuits.

In general, for the characterization of a dielectric material to be used for the transmission of high frequency signals, test boards are made with tracks of different length and the measurements of the known type are made in the specific techniques identified as "eye-diagrams". The eye-diagram is the tool suitable to the study of the quality of pseudo-casual digital signals transmitted through an electrical connection.

To connect the measuring instrument to the tracks on the printed circuit board, adapters of different type are used, according to the construction techniques of high frequency coaxial connectors, such as for instance surface mounted coaxial connectors (SMA), or employing lengths of cable for micro-wave fit with appropriate terminations.

Considering the frequencies in the GHz range, any discontinuity negatively affects the measurement; to correctly characterize the printed circuit board dielectric material, the measurement data shall be purified of SMA effects, like losses and impedance mismatch.

To do this, appropriate techniques shall be adopted, known as "de-embedding" techniques, in order to characterize the transfer function of the interconnection tracks, eliminating the SMA effects altering the measurements of eye-diagrams.

## Background art

There are calibration techniques of Vector Network Analyzer (VNA) enabling to purify the measurements from SMA effects.

1. These techniques are generally recalled in the VNA user manuals, such as for instance: Anritsu Model 37xxxC , Agilent/HP 8150, Agilent/HP 8510, and in technical publications like: G. F. Engen, C. A. Hoer, "Thru-reflect-line: An improved technique for calibrating the dual six-port automatic network analyzer", *IEEE Transactions on Microwave Theory and Techniques,* vol. MTT-22, pp.987-993, Dec. 1979

Calibration techniques avail also of "de-embedding" methods known to sector technicians and described in technical publications, such as:

1. G. Gronau, I. Wolff, "A Simple Broad-Band Device De-embedding Method Using an Automatic Network Analyzer with Time -Domain Option", IEEE Transactions on Microwave Theory and Techniques, vol. 37, no. 3, March 1989
2. L. Van Hauwermeiren, M. Botte, D. De Zutter, "A New De-Embedding Technique for On-Board Structures Applied to the Bandwidth Measurement of Packages", *IEEE Transactions on Components, Hybrids and Manufacturing Technology,* vol. 16, no. 3, May 1993

Among calibration procedures, the most common one is called Short-Open-Load-Thru (SOLT).

The limit of the SOLT method lays just in the fact that it is not possible to consider the SMAs, provided on the printed circuit board, which the instrument is connected to.

Other calibration procedures, known as Thru-Reflect-Line (TRL) calibration method, or Line-Reflect-Line (LRL) enable to characterize and separate the effects of the entry adapters from the actual measurements.

The TRL method foresees three phases, and for each of them the use of an appropriate transmission line is foreseen:

> 1. a first measurement made between two ports connected by a short line (THRU)
> 2. a second measurement made on an open line connected to each port (REFLECT)
> 3. a third measurement made between two ports connected by a line longer than that used for the first measurement (LINE)

The TRL method is not easy to use. In fact, if the frequency interval of the measurements is very large, as in modern transmission equipment, it must be divided into several sub-intervals and several transmission lines are necessary for each of them to perform the TRL calibration.

An additional drawback of the TRL method is represented by the fact that these tracks are specifically implemented for calibration; therefore they are either additional tracks, if foreseen in a printed circuit necessary for the realization of a product, or they require the realization of an appropriate test board.

It is now evident the need for and/or the usefulness of a method enabling a sector technician to evaluate the integrity of the signal transmitted from a track implemented on the printed circuit board that shall be used in the apparatus realization, without the need for implementing other tracks to perform the calibration, either on the same board or on another printed circuit board to be purposely implemented, and without any limitation in the bandwidth in which said signal integrity has to be inspected.

## Object and summary of the invention

The object of the present invention is to give an answer to these requirements.

Let's consider a printed circuit board where a connection track has been laid out, such as for instance a strip-line, between two surface mount adapters (SMA) to which a Vector Network Analyzer is connected.

Let L be the length of the strip-line with propagation constant $\gamma$ and characteristic impedance Zo for the quasi-TEM (Transverse Electro Magnetic) dominant propagation mode

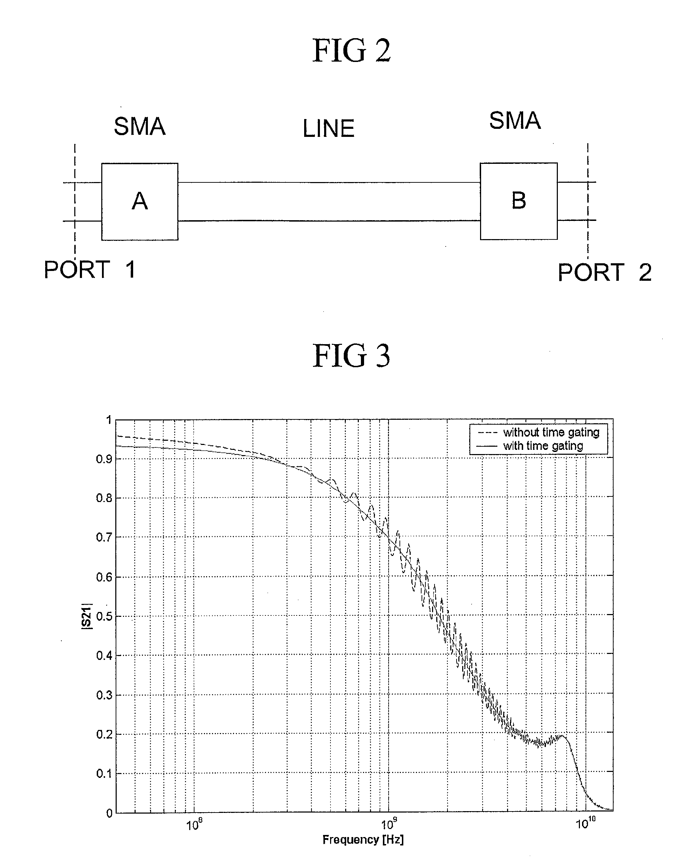

If Zo equals the normalization impedance, the parameter $S_{21}$ for the structure represented in Fig.2 is:

$$S^L{}_{21} = \frac{S^A_{21} S^C_{21}}{1 - S^A_{22} S^C_{11}}\, e^{-\gamma L}\,, \qquad (1)$$

where $S^{A,C}_{ii}$, $S^{A,C}_{ii}$ are the "scattering" parameters of the two SMA connectors: connector A and connector C.

Let's consider two tracks having length $L_1$ and $L_2$, each one having two SMA connectors at its ends, and having the same configuration (strip-line, microstrip,... belong to the same typology) and the same geometric dimensions, for the whole length L, compared to a cross section, and also that all SMA connectors can be considered alike.

Let $S^{L_1}$, $S^{L_2}$ be the "forward transmission scattering" parameters of the two tracks, as defined by expression (1).

From the ratio between these two parameters we obtain:

$$\gamma = \frac{1}{L_1 - L_2}\,\ln\frac{S^{L_2}_{21}}{S^{L_1}_{21}} \qquad (2)$$

"Scattering" parameters contained in (2) can be measured; consequently $\gamma$ is indirectly obtained through measurements.

The actual portion of the $\gamma$ keeps into account the attenuation along the lines, while its imaginary portion considers the phase variation introduced by each track.

After calculation of $\gamma$, as in (2), the transfer function of a board having length L is:

$$S_{21}{}^L = e^{-\gamma L} \qquad (3)$$

This transfer function is used to simulate the eye-diagram of a pseudo-casual signal travelling on said track.

## Brief description of figures

The present invention together with additional advantages, characteristics and applications thereof could be better understood from the following detailed description of a preferred embodiment, with reference to the figures in the attached drawings, in which:

> **figure 1** is the block diagram of a device for the determination of the transmission characteristics of dielectric materials based on the method scope of the present invention.
> **figure 2** describes the diagram of a strip-line with two SMAs used as terminations.
> **figure 3** describes the module $|S_{21}|$ in the case of 50 cm long track, before (dotted line) and after (continuous line) having eliminated the effect of undesired reflections.
> **figure 4** compares the module of a transfer function obtained after elimination of SMA effects with the proposed method and the same function when these were not removed.
> **figure 5** shows the eye-diagram at the end of a 70 cm strip-line when a pseudo-casual signal $2^{15}$-1,

coded "no return to zero (NRZ), 2,5 Gbps, is sent to its input without elimination of SMA effects.

**figure 6** shows the eye-diagram at the end of a 70 cm strip-line when a pseudo-casual signal $2^{15}$-1, coded "no return to zero (NRZ), 2,5 Gbps, is sent to its input and SMA effects have been eliminated according to the described technique.

## Description of a preferred embodiment of the invention

The embodiment of the invention shown in the figures and described below refers to the application of the method, scope of the invention.

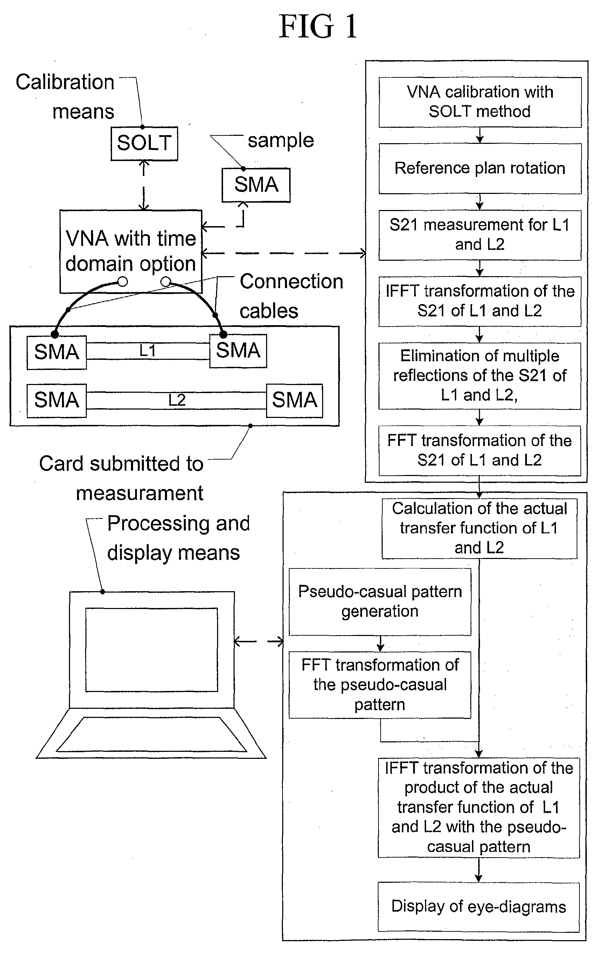

With reference to the figures, and in particular to figure 1, the method reference is made to, is implemented through the use of a measurement bench consisting of a VNA and a board submitted to measurement.

Two tracks are identified on the board submitted to measurement, like two strip-lines complying with the diagram represented in figure 2, both the strip-lines characterized by equal characteristic impedance (which in the experimental inspection described is equal to 50Ω) and the length equal to $L_1$ (which in the experimental inspection described is equal to 50 cm) and to $L_2$, (which in the experimental inspection described is equal to 70 cm), both realized on a printed circuit whose dielectric material has the value of the dielectric constant equal to $\varepsilon_r$ (which in the described experimental inspection is equal to 3,8 at 1 GHz frequency) and the loss tangent value is equal to tanδ (which in the experimental inspection described is equal to 0,007 at 1 GHz frequency).

Both the strip-lines have constant width and thickness for the section under measurement (in the experimental inspection described the width is equal to 250 μm and the thickness is equal to 18 μm).

The measurement frequency interval is 40 MHz - 13,75 GHz.

At the ends of said tracks suitable SMAs are connected, such as for instance, surface mount coaxial connectors or lengths of cable for micro-wave fit with appropriate ends.

The VNA is equipped with cables for connection to the device under test and calibrated with the SOLT method up to the ends of said cables, employing the calibration devices provided to this purpose and known to those skilled in the art.

At this point, the reference plan is "rotated" from the calibration plan to the device under measurement. The technique used to rotate the reference plan from the calibration plan to the device being measured is known as "port extension" and enables to keep into account the phase shift due to the SMAs, which are considered in this technique as ideal transmission lines without losses and well matched. The "port extension" operation is made employing a SMA adapter similar to those provided on the printed circuit board as termination of the tracks being measured.

Therefore the VNA is connected to the device under test.

The $S_{21}$ parameter is measured for both the lines in the frequency domain.

The Fourier reverse transform(IFFT) is applied to these parameters $S_{21}$, employing the "time domain" option present on the VNA, obtaining the same in the time domain.

These parameters $S_{21}$, in time domain, are purified of multiple reflections due to SMAs employing the "time gating" option present on the VNA.

The parameters so purified, are re-transformed in the frequency domain applying the Fourier transform (FFT) using again the "time domain" option present on the VNA.

Figure 3 shows the trend of the $|S_{21}|$ in the case of 50 cm long track, before and after elimination of the effect of undesired reflections.

Employing the $S_{21}$ values obtained from the measurements on the two tracks and then cleaned, we obtain the actual transfer function of the considered strip-lines through equation (2) and (3).

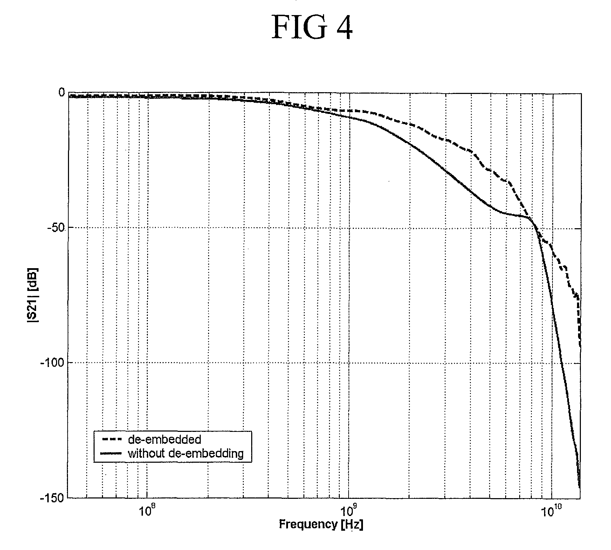

Figure 4 shows the comparison between the module of a transfer function so obtained and the same in the case in which SMA effects were not removed.

Employing the transfer function the eye-diagram can be reconstructed, through numeric simulation, at the end of the considered track.

This reconstruction, nowadays made with the aid of a VNA, a processor and the method described below, is represented in the block diagram of figure 1, and can also be performed by an instrument having the characteristics and processing capabilities of a VNA.

For the reconstruction of the eye-diagram at the end of any track present on the board submitted to test with the geometric characteristics of the two tracks having length $L_1$ and $L_2$ previously measured and characterized, the steps to be made are as follows:

- Generation, through processor, of a simulated pseudo casual pattern;
- Calculation of the Fourier Transform(FFT) of said simulated pattern
- Determination of the simulated signal in the frequency domain, at the connection end through product between the FFT of said simulated pattern and the transfer function proper of the connection;
- Fourier Anti-transform (IFFT) of the resulting simulated signal, in time domain;
- Displaying of the eye-diagram.

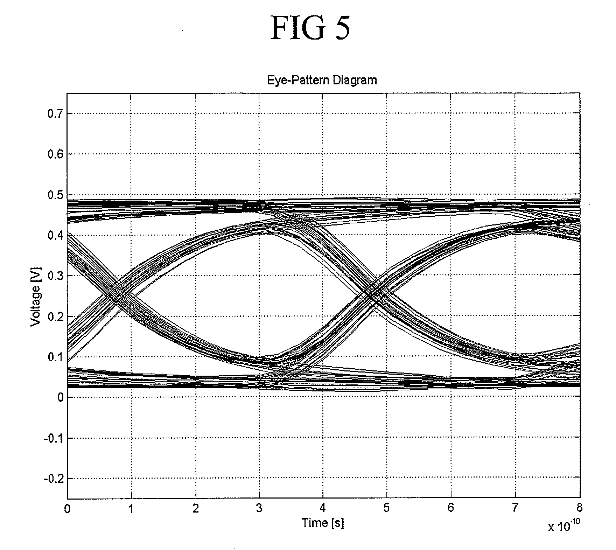

Figure 5 shows the eye-diagram at the end of the 70 cm strip-line when a pseudo-casual signal $2^{15}$-1, coded "no return to zero (NRZ), 2,5 Gbps, is sent to its input without elimination of SMAs effects.

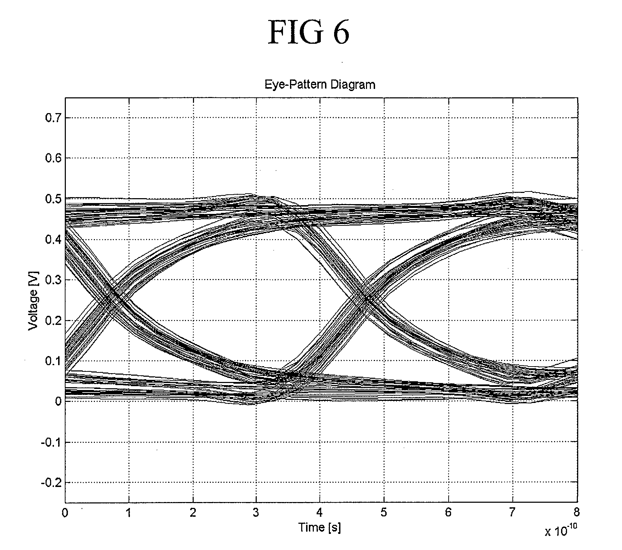

Figure 6 shows the eye-diagram at the end of the 70 cm strip-line when a pseudo-casual signal $2^{15}$-1,

coded "no return to zero (NRZ), 2,5 Gbps, is sent to its input and SMAs effects have been eliminated with the technique previously described.

## Claims

**1.** Method to determine the actual transfer function of an electrical connection implemented according to the printed circuit technology, of the type including the following steps:

a. Connecting an instrument for the measurement of S parameters both in the frequency domain and in the time domain, like a Vector Network Analyzer with Time Domain option, to test cables used for the instrument connection to measurement points;
b. calibrating the instrument following the technique known as Short-Open-Load-Thru employing appropriate calibration elements;
c. shifting the reference plan of the measurement from the calibration plan to the printed circuit according to the technique known as "port extension" employing an adapter equal to those used for the connection of test cables to the connections under measurement,
said method being **<u>characterized in that</u>** it foresees the following additional steps:
d. connecting the instrument to the printed circuit under measurement, on which two connections at least having significantly different length are realized and having equal construction geometry characteristics, dielectric and conductive material to which the measuring instrument has access through the adapters;
e. measuring the parameter

$$S_{21}^L = \frac{S_{21}^A S_{21}^C}{1 - S_{21}^A S_{21}^C}$$

concerning the first connection in the frequency domain where $S^{A,C}$, $S_{ii}^{A,C}$ are the "scattering" parameters of the two SMA connectors: connector A and connector C;
f. converting the measurement in time domain through the Fourier reverse transform (IFFT);
g. eliminating the $S_{21}^L$ parameter from multiple reflections due to the presence of the adapters through filtering in the time domain;
h. re-converting the measurement under point g) in the frequency domain through Fourier transform(FFT);
i. applying the steps described under e) f) g) h) to the second connection, obtaining $S_{21}^L$ from the second connection purified from multiple reflections due to the presence of adapters;

j. calculating the propagation constant

$$\gamma = \frac{1}{L_1 - L_2} \ln \frac{S_{21}^{L_2}}{S_{21}^{L_1}}$$

where the values of $S_{21}^{L1}$ and $S_{21}^{L2}$ measurements are those obtained at points h) and i)
k. calculating $|S_{21}^L| = |e^{-\gamma L}|$
l. determining the transfer function of the track having length $L_1$ employing the value defined under k) as module, and assuming as phase the one proper of the measurement of $S_{21}$ (of $L_1$) made under point e)
m. determining the transfer function of the track having length $L_2$ employing the value defined under point k) as module, and assuming as phase the one proper of the measurement of $S_{21}$ (of $L_1$) made under point i).

**2.** The method described in claim 1, **characterized in that** it is applied to an electrical connection of the "micro-strip" type, realized on the printed circuit in which the shape and size of the configuration cross section maintain constant along the track section considered;

**3.** The method described in claim 1, **characterized in that** it is applied to an electrical connection of the "embedded-micro-strip" type, realized on the printed circuit in which the shape and size of the configuration cross section maintain constant along the track section considered;

**4.** The method described in claim 1, **characterized in that** it is applied to an electrical connection of the "strip-line" type, realized on the printed circuit in which the shape and size of the configuration cross section maintain constant along the track section considered;

**5.** The method described in claim 1, **characterized in that** it is applied to any electrical connection of the type in which the length of tracks considered is such that there is no superimposition and interactions among the different reflected waves.

**6.** The method described in claim 1, **characterized in that** it is the difference in length of the tracks considered and represents 20% at least of the minimum length track ;

**7.** The method described in claim 1, **characterized in that** it foresees the use of adapters for the connection of test cables to the connections being measured, realized according to the construction techniques of high frequency coaxial connectors;

8. The method described in claim 1, **characterized in that** it foresees the use of adapters for the connection of test cables to the connections being measured realized employing lengths of cable for microwave;

9. Device to determine the eye-diagram operating in accordance with the method described in the preceding claim 1, including:

   - software means for the generation of a pseudo-casual pattern
   - display means
   - processing means
   - **characterized in that** it also includes:

     n    pseudo casual pattern generation means
     o    means suitable to perform the Fourier Transform (FFT) of said pseudo casual pattern
     p    means suitable to determine the actual transfer function of the connection in accordance to claims 1 through 8
     q    means suitable to determine in the frequency domain of the simulated signal at the connection termination through product between the signals corresponding to the output of the preceding means o) and p).
     r    means suitable to perform the Fourier anti-transform (IFFT) of the signal resulting at the output of the means mentioned under q) in time domain.
     s    means suitable to determine the eye displaying

10. Device for the determination of transmission characteristics of dielectric materials, **characterised in that** it includes means suitable to perform the comparison of the eye-diagrams obtained on the basis of what specified in the previous claim 9.

# FIG 1

Calibration means

SOLT

sample

SMA

VNA with time domain option

Connection cables

SMA —— L1 —— SMA

SMA —— L2 —— SMA

Card submitted to measurament

Processing and display means

VNA calibration with SOLT method

Reference plan rotation

S21 measurement for L1 and L2

IFFT transformation of the S21 of L1 and L2

Elimination of multiple reflections of the S21 of L1 and L2,

FFT transformation of the S21 of L1 and L2

Calculation of the actual transfer function of L1 and L2

Pseudo-casual pattern generation

FFT transformation of the pseudo-casual pattern

IFFT transformation of the product of the actual transfer function of L1 and L2 with the pseudo-casual pattern

Display of eye-diagrams

# FIG 2

SMA          LINE          SMA

A                                              B

PORT  1                              PORT  2

# FIG 3

# FIG 4

# FIG 5

Eye-Pattern Diagram

# FIG 6

Eye-Pattern Diagram

EP 1 424 565 A1

**European Patent Office**

**EUROPEAN SEARCH REPORT**

Application Number

EP 02 42 5736

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | GRONAU G: "Scattering-parameter measurement of microstrip devices" MICROWAVE JOURNAL, NOV. 1992, USA, vol. 35, no. 11, November 1992 (1992-11), pages 82, 84, 86, 89-92, XP000332546 ISSN: 0026-2897 | 1 | G01R31/28 G01R27/28 |
| X | * page 82, left-hand column, line 12-14 * * section 'ANA Calibration Using The Time Domain Option' on pages 84 and 86 * * figures 7-10 * | 9,10 | |
| D,A | VAN HAUWERMEIREN L ET AL: "A NEW DE-EMBEDDING TECHNIQUE FOR ON-BOARD STRUCTURES APPLIED TO THE BANDWIDTH MEASUREMENT OF PACKAGES" IEEE TRANSACTIONS ON COMPONENTS,HYBRIDS,AND MANUFACTURING TECHNOLOGY, IEEE INC. NEW YORK, US, vol. 16, no. 3, 1 May 1993 (1993-05-01), pages 300-303, XP000393472 ISSN: 0148-6411 | 1 | |
| | | | TECHNICAL FIELDS SEARCHED (Int.Cl.7) |
| X | * page 300, section 'II. MEASUREMENT SETUP' * | 9,10 | G01R |

-----

The present search report has been drawn up for all claims

| Place of search | Date of completion of the search | Examiner |
|---|---|---|
| MUNICH | 31 March 2003 | Jakob, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)